# EUROPEAN PATENT APPLICATION

(11) **EP 0 814 504 A2**
(43) Date of publication of application: **29.12.1997**
(21) Application number: 97108814.1
(22) Date of filing: 02.06.1997
(51) Int. Cl.: H01L 21/48, H01L 23/538

(54) **Semiconductor mounting substrate having micronized wire and method of manufacturing the same**

(30) Priority: 18.06.1996 JP 156881/96
(71) Applicant: NEC CORPORATION, Tokyo (JP)
(72) Inventor: Shibuya, Akinobu, Minato-ku, Tokyo (JP); Kimura, Mitsuru, Minato-ku, Tokyo (JP)
(74) Representative: Glawe, Delfs, Moll & Partner

(57) **Abstract**

Without using a photolithography technique, a semiconductor mounting substrate having micronized wirings can be obtained by simple manufacturing steps in a short time. Flaws 2 are formed in a substrate 1, and metalized layers 3 by en electroless plating are formed thereon, whereby micronized wirings are formed. Moreover, the flaws 2 are formed also by laser or a diamond indentation tool to which ultrasonic wave is applied.

## Description

### BACKGROUND OF THE INVENTION

### 1. Field of the Invention

The present invention relates to a structure of a semiconductor mounting substrate having micronized wires and a method of manufacturing the same, more particularly to a method of manufacturing a low-cost semiconductor mounting substrate having micronized wires which has been considered to be impossible.

### 2. Description of the Related Art

Recent years, it has been eagerly desired that a semiconductor mounting substrate should be sealed in a CSP ( a chip size package ). More micronization and high density of the wires have been demanded. On the other hand, a low-cost of the semiconductor mounting substrate has been demanded.

A ceramic substrate, a glass ceramic substrate and a print wiring substrate have been used for the semiconductor mounting substrate. In the ceramic substrate and the glass ceramic substrate, a metalized layer is generally formed with a thick film so that they are excellent in a massproduction.

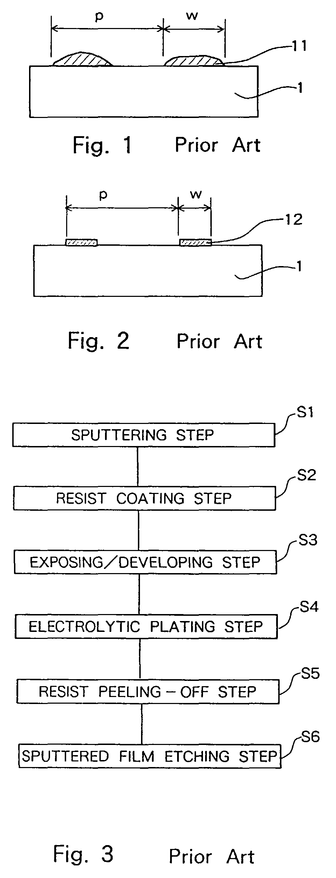

However, because the thick metalized layer is formed by a screen printing, it involves a problem that it is hard to be micronized. A ceramic multilayer wiring substrate and a glass ceramic multilayer wiring substrate involves the same problem as that of the thick metalized layer, since they are formed by carrying out the thick film printing with paste on a green sheet. Fig. 1 is a schematic section view showing a wiring portion of a conventional thick film wiring mounting substrate. In Fig. 1, the minimum values of a wiring width w and a wiring pitch p of the thick film metalized layer 11 on the substrate 1 are limited to 50 µm and 100 µm, respectively. This is because a method is adopted which the paste is ejected from meshes of the screen and is transferred onto the substrate. Furthermore, since the metalized layer is formed by a printing method, a flat conductive body can not be obtained.

The disadvantage produced from the limitation to the micronization results in the following problem. Specifically, an area of the substrate becomes large and moreover the number of layers becomes large in case of the multilayer wiring substrate because of the limitation to an increase in a wiring density for one layer. Therefore, it will be impossible to reduce cost by reduction of the number of the layers.

For this reason, in case where it is intended to form more micronized wiring, formation of the metalized layer utilizing a thin film method has been conducted. The formation technique for the metalized layer by the thin film method is used also for a printed wiring substrate and a build up substrate. Fig. 2 shows a schematic section view showing a wiring portion of the conventional thin film wiring mounting substrate formed by the thin film method. When the thin film method is used, a more micronized and flat wiring can be formed compared with the thick film method. Although a wiring width w and a wiring pitch p of a thin film metalized layer 12 differ from those of the thick film metalized layer depending on the kind of the substrate 1, the minimum values that can be formed on them are 10 µm and 20 µm, respectively.

However, as shown in a flow chart of Fig. 3 as an example of formation of the metalized layer using the thin film method, the thin film method requires many steps such as a sputtering step ( S1 ), a resist coating step ( S2 ), exposing/developing step ( S3 ), an electrolytic plating step ( S4 ), a resist peeling-off step ( S5 ) and a sputtered film etching step ( S6 ), resulting in a low productivity and an increase in cost. In the multilayer wiring printing board, since it is manufactured by etching a copper coated laminated substrate using photolithography technique, the same problem is arises.

As a manufacturing method of inner leads of the ceramic package according to the thick film method in which the metalized layer for wiring can be formed in a low cost, a manufacturing method has been reported in Japanese Patent Application Laid Open No. Heisei 4-83392, in which a conductive printing portion before baking is cut using a scriber by laser. According to this method, although the flat conductive body can be formed, the width and the pitch of the conductive body are 80 to 160 µm and 120 to 200 µm, respectively, so the conductive body is inferior to that by the thin film method.

As described above, in the wiring formation method of the conventional semiconductor mounting substrate, it has been proved that a low cost and a micronization of wirings can not be incompatible. Specifically, according to the conventional thick film method, although thick film method is excellent in productivity and low in cost, this method has a problem concerning formation of micronized wiring. According to the thin film method, although the thin film method is capable of forming micronized wiring, this method increases the number of steps so that reduction in cost is difficult.

### SUMMARY OF THE INVENTION

Therefore, the object of the present invention is to provide a semiconductor mounting substrate having a low-cost micronized wiring and a method of manufacturing the same.

To achieve the foregoing object, the semiconductor mounting substrate having a micronized wiring according to the present invention comprises a micronized wiring in which a metalized layer is formed in a flaw portion formed in the semiconductor mounting substrate by electroless plating.

In another embodiment of the present invention, a semiconductor mounting substrate which is multilayered and has a micronized wiring comprises a micronized wiring in which the metalized layer is formed in a flaw portion formed in the semiconductor mounting substrate by electroless plating.

Furthermore, in still another embodiment of the present invention, a semiconductor mounting substrate having micronized wirings, in which substrates are multilayered, comprises the micronized wirings formed of a metalized layer which is formed in a flaw portion formed only on a top substrate of said semiconductor mounting substrate by an electroless plating.

The micronized wirings includes micronized leads or pads besides wirings.

A method of manufacturing a semiconductor mounting substrate having micronized wirings according to the present invention comprises a scribing step and an electroless plating step, said scribing step being for forming flaws by scribing and said electroless step being for metalized layers in flaw portions in said substrate.

The above and other object, features, and advantages of the present invention will become apparent from the following description based on the accompanying drawings which illustrate an example of a preferred embodiment of the present invention.

### BRIEF DESCRIPTION OF THE DRAWINGS

Fig. 1 is a schematic section view showing a wiring portion of a conventional thick film wiring mounting substrate.

Fig. 2 is a schematic section view showing a wiring portion of a conventional thin film wiring mounting substrate.

Fig. 3 is a process flow chart showing an example of formation of the conventional thin film wiring mounting substrate.

Fig. 4 is a schematic section view showing a semiconductor mounting substrate having a micronized wiring according to an embodiment of the present invention.

Fig. 5 is an enlarged schematic section view showing a micronized wiring portion according to an embodiment of the present invention.

Fig. 6 is an enlarged schematic section view showing a micronized wiring portion according to an embodiment of the present invention.

Fig. 7 is an enlarged schematic section view showing a micronized wiring portion according to an embodiment of the present invention.

Fig. 8 is a process flow chart showing a method of manufacturing a semiconductor mounting substrate having a micronized wiring according to an embodiment of the present invention.

Fig. 9 is a schematic side view for explaining a method of manufacturing a micronized wiring mounting substrate according to an embodiment of the present invention.

Fig. 10 is a schematic side view explaining a method of manufacturing the micronized wiring mounting substrate according to the embodiment of the present invention.

Fig. 11 is a schematic plan view for explaining an example of the micronized wiring mounting substrate according to the embodiment of the present invention.

### DETAILED DESCRIPTION OF THE PREFERRED EMBODIMENTS

Next, an embodiment of the present invention will be described in detail with reference to the accompanying drawings.

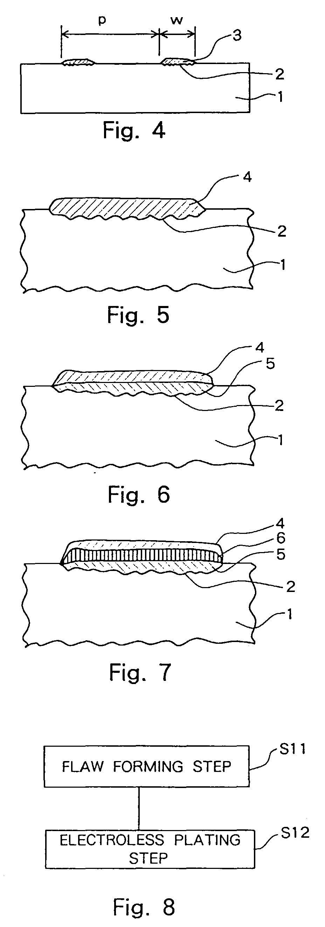

Fig. 4 is a section view showing a semiconductor mounting substrate having a micronized wiring according to an embodiment of the present invention. In Fig. 4, a substrate 1 having a micronized wiring according to the present invention has a structure that a flaw 2 having a width equal to that of a wiring is formed by scribing on a surface of the substrate 1 and a micronized wiring formed of an electroless plating metalized layer 3 is formed on the flaw 2 formed by scribing. A width w and a pitch p of the micronized wiring formed of the electroless plating metalized layer 3 is 10 to 100 µm and 20 µm or more, respectively, that is their minimum values are 10 µm and 20 µm, respectively.

Furthermore, a ceramic substrate, a glass ceramic substrate, a glass substrate, a thick film multilayer board, a printing board, a built-up substrate and the like are used for the substrate 1, materials of the substrate are not limited to them.

Figs. 5, 6 and 7 are enlarged sectional views of the wiring portion. Fig. 5 shows the case where the number of electroless plating metalized layer is one, Fig. 6 shows the case where their number is two, and Fig. 7 shows the case where their number is three. In case of Fig. 5, a low resistance plating layer 4 is used for the electroless plating metalized layer 3, and materials such as Cu, Au and Ag are used for the plating layer 4. In case of Fig. 6, two layers formed of the low resistance plating layer 4 and an adhesion plating layer 5 are used for the electroless plating metalized layer 3, and material such as Ni, Pd and Cu are used for the adhesion plating layer 5. In case of Fig. 7, three layers formed of the low resistance plating layer 4, a barrier plating layer 6 and the adhesion plating layer 5 are used for the electoless plating metalized layer 3, and materials such as Ni, Ru, Rh are used for the barrier plating layer 6. It should be noted that the materials for the plating layers are not limited to these substances.

Furthermore, for the number of the plating layers forming the electroless plating layer 3, the case of one layer shown in Fig. 5 is most preferable from the view point of cost. The low resistance plating layer 4 has also a adhesion function, more than two layers are used depending on use, and the number of the layers is not limited to the cases shown in Figs. 5, 6 and 7.

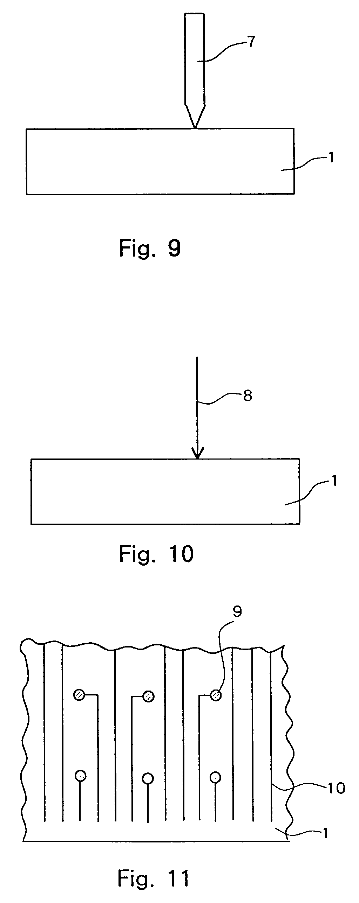

Fig. 8 shows a flow chart of a method of manufacturing a semiconductor mounting substrate having a micronized wiring according an embodiment of the present invention. Specifically, the manufacturing method of this embodiment comprises a formation step ( S11 ) for forming a flaw in the substrate by scribing and an electroless plating step ( S12 ). In the formation step for forming the flaw in the substrate by scribing, as shown in Figs. 9 and 10, the flaw is formed in the substrate 1 using a laser light 8 or a diamond indentation tool to which a ultrasonic vibration is applied. In the subsequent step, the metalized layer 3 is formed on the flaw 2 of the substrate 1 by electroless plating, whereby the micronized wiring is provided.

As described above, it is apparent that the number of the manufacturing steps of the present invention is less than that of the conventional thin film manufacturing steps. For formation method to form the flaw 2 in the substrate 1 by scribing, the above described two kinds of the methods are preferably employed. However, the method for forming the flaw 2 in the substrate 1 is not limited to these methods.

The flaw 1 formed by scribing can be formed in the desired pattern using an apparatus which is controlled by data previously input concerning a wiring to be formed.

Furthermore, in the electroless plating step, a Cu electroless plating after being activated by Pd catalyst is preferably used. However, the kinds of the electroless plating metalized layer are never limited as described above.

Moreover, instead of the copper coated laminated substrate which has been used, using the substrate having the micronized wiring according to the present invention, stacking of layers through a pre-preg, formation of through holes and plating in the through holes are conducted, whereby the substrate having multilayered micronized wirings can be manufactured. Moreover, also using the technology of the present invention for the wiring manufacture on each of the layers constituting the thick film multilayer substrate, the semiconductor mounting substrate having the multilayer micronized wiring can be manufactured. A build-up substrate can also be manufactured, similarly.

Furthermore, it is also possible to form micronized wiring including either a micronized lead 10 or a pad, using the technology of the present invention, only on a top layer of a multilayer wiring mounting substrate manufactured by the conventional method as shown in Fig. 11. Such micronized wiring can be used for performing connection with micronized pitch which has been impossible. This multilayer wiring semiconductor mounting substrate can be widely used for various kinds of substrates without any limitation.

Next, an embodiment of the present invention will be described with reference to drawings and a table.

### ( Embodiment 1 )

An alumina ceramic substrate is used for a substrate 1, and flaws 2 are formed on the substrate 1 with a width of 10 µm by scribing using a diamond indentation tool 7, intervals between the flaws 2, that is, the pitches of the flaws 2 have various kinds of values. Thereafter, the substrate 1 is subjected to degreasing cleaning, and, then, the substrate 1 is immersed in mixed hydrochloric aqueous solution containing palladium chloride and stannous chloride. Thereafter, the substrate 1 is cleaned in sulfuric acid solution to be activated. The substrate 1 is immersed in electroless copper plating solution, whereby the substrate 1 having micronized wirings is completed.

Width w of the micronized wiring and the minimum wiring pitch p which could be realized are collectively shown in Table 1. The micronized pitch wiring which has been impossible with the thick film printing method can be formed in a short time by less steps than the conventional thin film method.

### ( Embodiment 2 )

A glass ceramic substrate was used for the substrate 1, and the substrate having micronized wirings was manufactured by the same way as the embodiment 1. The results are shown in Table 1.

### ( Embodiment 3 )

A glass substrate was used for the substrate 1, and the substrate having micronized wirings was manufactured by the same way as the embodiment 1. The results are shown in Table 1.

### ( Embodiment 4 )

FR-4 resin which is a material for a printing board was used for the substrate 1, and the substrate having micronized wirings was manufactured by the same way as the embodiment 1. The results are shown in Table 1.

### ( Embodiment 5 )

A resin substrate having micronized multilayer wirings manufactured in the same manner as in the embodiment 4 was stacked interposing pre-preg by the same steps for the conventional multilayer printing wiring substrate. The stacked substrates were subjected to formation of through holes and plating within the through holes, whereby the substrate having the micronized multilayer wiring was manufactured. The substrate having more micronized wiring than the conventional multilayer wiring board could be manufactured in a short time by steps less than the conventional multilayer printing wiring board. Wiring connection degree between the substrates was good.

### ( Embodiment 6 )

An alumina ceramic multilayer wiring substrate having a tungsten ( W ) multilayer wiring therein and only via 9 of 250 µm diameter on the surface layer thereof was used for the substrate 1, and the substrate having the micronized wiring connected to the via 9 was manufactured according to the method similar to that of the embodiment 1. At the time of manufacturing the wiring portion, scribing for the connection portion with the via 9 was conducted to the center of the via. The minimum pitches p which could be manufactured are collectively shown in Table 1. Connection degree of the via 9 with the micronized wiring 1 formed was good.

### ( Embodiment 7 )

An alumina ceramic multilayer wiring substrate having AgPd multilayer wiring therein and having only a via 9 of 20 µm diameter on the surface layer thereof was used for the substrate 1, and the substrate having micronized wirings connected to the via 9 was manufactured according to the same method as that of the embodiment 6. The minimum pitches p which could be formed are collectively shown in Table 1. Connection degree of the via of the substrate with the micronized wiring formed was good.

### ( Embodiment 8 )

A Cu multilayer wiring printing substrate was used for the substrate 1, and the substrate having micronized wiring was manufactured according to the same method as the embodiment 1. However, at the time of manufacturing this wiring portion, scribing for the connection portion with the through hole was conducted so as to make connection to the end of the through hole. The minimum pitches p which could be formed are collectively shown in Table 1. Connection degree of the via of the substrate with the micronized wiring formed was good.

### ( Embodiment 9 )

A Cu wiring build-up substrate was used for the substrate 1, and the substrate having micronized wiring was manufactured according to the same method as the embodiment 8. The minimum pitches which could be formed are collectively shown in Table 1. Connection degree of the via of the substrate with the micronized wiring formed was good.

### ( Embodiment 10 )

A multilayer thick film substrate with AgPd wiring was used for the substrate 1, and the substrate having micronized wiring was manufactured according to the same method as the embodiment 7. Connection degree of the via 9 of the substrate with the micronized wiring formed was good.

### ( Comparison Example 1 )

An alumina ceramic substrate was used for the substrate 1, and the substrate 1 was subjected to screen printing by W paste. Thereafter, the W wiring having various kinds of wiring width w and pitches p was formed by baking. The results are shown in Table 1.

### ( Comparison Example 2 )

A glass ceramic substrate was used for the substrate 1, and the substrate 1 was subjected to screen printing with Ag-Pd group alloy paste. Thereafter, the substrate 1 was baked, whereby Ag-Pd group alloy wirings having various kinds of wiring widths w and pitches p were formed. The results are shown in Table 1.

### ( Comparison Example 3 )

A copper coating FR-4 resin stacked board for use in a printing board was used, and Cu wirings having various kinds of wiring widths w and pitches p were formed by resist coating, exposing, developing, and etching which are included in ordinary printing board manufacturing steps. The results are shown in Table 1.

### ( Comparison Example 4 )

A thin film was formed on a FR-4 resin material for use in a printing board by sequentially sputtering Cr and Pd, and Cu wirings having various kinds of wiring widths w and pitches p by resist coating, exposing, developing, electrolytic plating, and etching steps. The results are shown in Table 1.

**TABLE 1**

| | SUBSTRATE | METHOD OF FORMING WIRING | w (µ m) | p (µ m) | STEP |
|---|---|---|---|---|---|
| EMBODIMENT 1 | ALUMINA SUBSTRATE | SCRIBING ELECTROLESS Cu PLATING | 10 | 20 | SHORT |
| EMBODIMENT 2 | GLASS SERAMIC SUBSTRATE | SCRIBING ELECTROLESS Cu PLATING | 10 | 20 | SHORT |
| EMBODIMENT 3 | GLASS SUBSTRATE | SCRIBING ELECTROLESS Cu PLATING | 10 | 20 | SHORT |
| EMBODIMENT 4 | PRINTING BOARD | SCRIBING ELECTROLESS Cu PLATING | 10 | 20 | SHORT |
| EMBODIMENT 6 | MULTILAYER W WIRING ALUMINA SUBSTRATE | SCRIBING ELECTROLESS Cu PLATING | 10 | 20 | SHORT |
| EMBODIMENT 7 | MULTILAYER AgPd WIRING GLASS CERAMIC SUBSTRATE | SCRIBING ELECTROLESS Cu PLATING | 10 | 20 | SHORT |
| EMBODIMENT 8 | MULTILAYER Cu WIRING PRINTING BOARD | SCRIBING ELECTROLESS Cu PLATING | 10 | 20 | SHORT |
| EMBODIMENT 9 | MULTILAYER Cu WIRING BUILD - UP SUBSTRATE | SCRIBING ELECTROLESS Cu PLATING | 10 | 20 | SHORT |
| EMBODIMENT 10 | AgPd THICK FILM MULTILAYER SUBSTRATE | SCRIBING ELECTROLESS Cu PLATING | 10 | 20 | SHORT |
| COMPARISON EXAMPLE 1 | ALUMINA SUBSTRATE | W PASTE PRINTING BAKING | 70 | 140 | SHORT |
| COMPARISON EXAMPLE 2 | GLASS CERAMIC SUBSTRATE | AgPd PASTE PRINTING BAKING | 50 | 100 | SHORT |
| COMPARISON EXAMPLE 3 | COPPER COATING FR-4 STACKED BOARD | PHOTOLITHOGRAPHY ETCHING Cu | 40 | 80 | LONG |
| COMPARISON EXAMPLE 4 | FR-4 RESIN SABSTRATE | ELECTROLYTIC Cu PLATING PHOTOLITHOGRAPHY ETCHING | 30 | 70 | LONG |

As described above, according to the present invention, a semiconductor mounting substrate which is low in cost and highly integrated can be provided. Therefore, a high integration and miniaturization of various kinds of devices can be achieved.

Furthermore, when comparing with the conventional thick film wiring technique, the wirings are largely micronized so that miniaturization of the substrate and formation of a micronized connection pad connected to a chip can be easily conducted. The reason is as follows. Since a conductive paste is conducted by screen printing in the conventional thick film wiring technique, it was restricted by the printing limitation of paste. However, in the formation of the present invention, flaws are formed on the substrate by a diamond indenting tool, laser light or the like without interposing the screen and the like, and an electroless plating layers are formed in the flaw portions.

When comparing with the conventional thin film wiring technique, a time for performing steps is largely reduced and reduction in cost can be realized. This is because the flaws are directly formed on the substrate without passing through a sputtering step and a photolithography step and electoless plating layers are simply formed on the flaw portions.

Although the preferred embodiments of the present invention has been described in detail, it should be understood that various changes, substitutions and alternations can be made therein without departing from spirit and scope of the inventions as defined by the appended claims.

## Claims

1. A semiconductor mounting substrate having micronized wirings comprising:
a substrate, and micronized wirings being formed of metalized layers by an electroless plating in flaw portions formed on said substrate.

2. A semiconductor mounting multilayered substrate composed of a plural number superposed substrates having micronized wirings comprising:
a substrate, and micronized wirings being formed of metalized layers by an electroless plating in flaw portions formed on at least two substrates in said multilayered substrates.

3. A semiconductor mounting substrate composed of a plural number superposed substrates having micronized wirings comprising:
a substrate, and micronized wirings being formed of metalized layers by an electroless plating in flaw portions which are formed only on a substrate disposed in the top of said semiconductor mounting substrates.

4. The semiconductor mounting substrate having micronized wirings according to claim 1, wherein said semiconductor mounting substrate comprises micronized wirings in which more micronized leads and pads are included therein.

5. The semiconductor mounting substrate having micronized wirings according to claim 2, wherein said semiconductor mounting substrate comprises micronized wirings in which more micronized leads and pads are included therein.

6. The semiconductor mounting substrate having micronized wirings according to claim 3, wherein said semiconductor mounting substrate comprises micronized wirings in which more micronized leads and pads are included therein.

7. A method of manufacturing a semiconductor mounting substrate having micronized wirings comprising the steps of:
forming flaws in said substrate by scribing, and
forming a metalized layer on a flaw portion of said substrate by an electroless plating.

8. The method of manufacturing a semiconductor mounting substrate having micronized wirings according to claim 7, wherein said step for forming said flaw in said substrate include a step of scribing by a diamond indenting tool.

9. The method of manufacturing a semiconductor mounting substrate having micronized wirings according to claim 7, wherein said step for forming said flaw in said substrate include a step of scribing by laser light.

10. The method of manufacturing a semiconductor mounting substrate having micronized wirings according to claim 7, wherein said electroless plating step is a processing step for forming one metalized layer in said flaw in said substrate by an electroless plating technique, said metalized layer being formed of a low resistance plating layer.

11. The method of manufacturing a semiconductor mounting substrate having micronized wirings according to claim 7, wherein said electroless plating step is a processing step for forming two metalized layers in said flaw in said substrate, said two metalized layers being composed of a low resistance plating layer and an adhesion plating layer formed by an electroless plating.

12. The method of manufacturing a semiconductor mounting substrate having micronized wirings according to claim 7, wherein said electroless plating step is a processing step for forming three metalized layers in said flaw in said substrate, said two metalized layers being composed of a low resistance plating layer, a barrier plating layer and an adhesion plating layer formed by an electroless plating.
